Europäisches Patentamt

European Patent Office

Office européen des brevets

(19)

(11) **EP 0 620 641 B1**

(12)

# FASCICULE DE BREVET EUROPEEN

(45) Date de publication et mention
de la délivrance du brevet:
**04.06.1997 Bulletin 1997/23**

(51) Int Cl.6: **H03H 17/02**

(21) Numéro de dépôt: **94400780.6**

(22) Date de dépôt: **11.04.1994**

(54) **Dispositif de traitement de signaux utilisant plusieurs filtrages différents, notamment pour le codage audiofréquence de signaux vocaux**

Signalverarbeitungsanordnung mit mehreren verschiedenen Filtern, insbesondere für audiofrequente Codierung von Stimmensignalen

Signal processing device using a plurality of different filters, in particular for coding of audiofrequency voice signals

(84) Etats contractants désignés:
**DE GB**

(30) Priorité: **16.04.1993 FR 9304532**

(43) Date de publication de la demande:
**19.10.1994 Bulletin 1994/42**

(73) Titulaire: **FRANCE TELECOM**
**75015 Paris (FR)**

(72) Inventeurs:
• **Balestro, Freddy**
**F-38000 Grenoble (FR)**
• **Senn, Patrice**
**F-38000 Grenoble (FR)**

(74) Mandataire: **Bulle, Françoise**
**Bureau D.A. Casalonga-Josse**
**Morassistrasse 8**
**80469 München (DE)**

(56) Documents cités:
**EP-A- 0 212 950        EP-A- 0 380 350**

• **IEEE JOURNAL OF SOLID-STATE CIRCUITS,**
**vol.15, no.6, Décembre 1980, New York, US, pp.**
**1014-1021; HIROSHI KUWAHARA et al.: 'AN**
**INTERPOLATIVE PCM CODEC WITH**
**MULTIPLEXED DIGITAL FILTERS'**

**Description**

L'invention concerne le traitement de signaux comportant l'utilisation de plusieurs filtres numériques ayant des gabarits sensiblement homothétiques, notamment dans le cadre de conversions analogique/numérique et numérique/analogique de signaux susceptibles de présenter des spécificités de transmission différentes.

L'invention s'applique particulièrement mais non exclusivement aux dispositifs de codage audiofréquence qui peuvent être utilisés pour de nombreuses applications de codage de signaux vocaux de haute qualité. De tels dispositifs de codage peuvent être insérés dans des terminaux audiofréquences, comme par exemple un téléphone du type mains libres.

Le document "IEEE Journal of solid-state circuits", vol. 15, no 6, décembre 1980 New York, U.S., pages 1014-1021, Hiroshi Kuwaharo et al. "An interpolative PCM codec with multiplexed digital filters" divulgue un exemple de filtre numérique.

Un téléphone mains libres comporte une voie de conversion analogique/numérique, dite voie d'émission, partant du microphone et allant vers le canal de transmission de données numériques, ainsi qu'une voie de conversion numérique/analogique, dite voie de réception, partant du canal numérique en direction du haut-parleur de ce téléphone.

Les signaux transitant sur ces canaux analogiques et numériques doivent satisfaire à des spécificités de transmission prédéterminées, généralement régies par des normes de transmission, telles que les normes CCITT G 722 ou CCITT G 711. Les voies d'émission et de réception de ces dispositifs comportent des filtrages dont les gabarits fréquentiels d'affaiblissement sont spécifiés en fonction des normes de transmission utilisées. Par ailleurs, les gabarits fréquentiels d'affaiblissement ne sont pas identiques en émission et en réception pour une norme donnée. Aussi, est-il nécessaire de prévoir dans ces dispositifs autant de filtres numériques que de gabarits fréquentiels nécessaires ce qui est contraignant du point de vue emplacement et coût de fabrication.

L'invention telle que définie dans les revendications vise d'une façon générale à apporter une solution plus satisfaisante, du point de vue encombrement et coût de fabrication notamment, au problème de l'utilisation de plusieurs filtres numériques ayant des gabarits sensiblement homothétiques comme c'est le cas par exemple dans les normes de transmission G711 et G722.

L'invention propose donc d'une façon générale, un dispositif de traitement de signaux, comportant un filtre numérique unique dont la fréquence de coupure dépend de la fréquence d'échantillonnage du signal présent à son entrée, et possédant un unique gabarit fréquentiel d'affaiblissement prédéterminé compatible avec une pluralité de gabarits fréquentiels d'affaiblissement élémentaires prédéterminés sensiblement homothétiques et associés à différents types de signaux susceptibles d'être traités.

Selon un mode de réalisation de l'invention, plus particulièrement applicable à la conversion analogique/numérique et numérique/analogique dans le cadre du codage de signaux audiofréquences, le dispositif comprend une première entrée et une première sortie, associées à une première voie de transmission, par exemple la voie d'émission, susceptibles de recevoir et de délivrer une pluralité de signaux analogiques et de signaux numériques correspondants ayant des types de spécificités de transmission prédéterminés différents (par exemple répondant aux normes G711 ou G722) et associés à des gabarits fréquentiels d'affaiblissement élémentaires (ici d'émission) prédéterminés et sensiblement homothétiques, ainsi qu'une deuxième entrée et une deuxième sortie associées à une deuxième voie de transmission (par exemple la voie dde réception) susceptibles de recevoir et délivrer une pluralité de signaux numériques et de signaux analogiques correspondant ayant des types de spécificités de transmission prédéterminés différents (répondant également par exemple aux normes G711 ou C722), et associés à des gabarits fréquentiels d'affaiblissement élémentaires (ici de réception) prédéterminés et sensiblement homothétiques; le dispositif comprend également des premiers et des deuxièmes moyens de conversion de signal, respectivement disposés entre les premières entrée et sortie et entre les deuxièmes entrée et sortie, et comportant, en commun, ledit filtre numérique unique.

Les deux voies de transmission reliant respectivement les deux entrées et les deux sorties correspondantes, possèdent avantageusement un bus série commun sur lequel est connecté le filtre numérique série unique, ainsi que des moyens de multiplexage et de démultiplexage des échantillons numériques issus des signaux reçus sur les deux entrées. Un tel agencement permet notamment de réduire encore l'implantation des différents éléments du dispositif sur une pastille de silicium.

Selon un mode de réalisation de l'invention, la deuxième voie, reliant l'entrée de signal numérique à la sortie de signal analogique comporte des moyens de suréchantillonnage du signal numérique d'entrée, ces moyens de suréchantillonnage précèdant le filtre numérique unique; par ailleurs, la première voie, reliant l'entrée de signal analogique à la sortie de signal numérique, comporte des moyens de sous-échantillonnage du signal numérique issu du filtre numérique.

Lorsque, comme c'est par exemple le cas dans les normes G711 ou G722, pour un couple de signaux analogique et numérique correspondant et répondant aux mêmes spécificités de transmission, c'est-à-dire par exemple à la même norme de transmission, les gabarits fréquentiels d'affaiblissement élémentaires sont différents sur la première voie et sur la deuxième voie (c'est-à-dire en réception et en émission), le gabarit fréquentiel d'affaiblissement du filtre numérique unique est alors avantageusement choisi à partir des gabarits les plus sévères associés respectivement à tous les couples de signaux susceptibles d'être traités.

Il s'est avéré préférable d'utiliser comme filtre numérique unique un filtre récursif en échelle à réponse impulsionnelle infinie.

Selon un mode de réalisation de l'invention, également applicable au codage audiofréquence de signaux vocaux, la première voie de transmission comporte un codeur analogique/numérique à mise en forme du spectre de bruit, tel qu'un codeur de type delta-sigma, suivi d'un filtre numérique du type bloqueur; dans ce cas, le filtre numérique unique incorpore avantageusement un bloqueur d'ordre choisi, pour compenser l'effet du filtre numérique du type bloqueur situé derrière le codeur analogique/numérique; par ailleurs, la deuxième voie de transmission comporte un codeur numérique/analogique à mise en forme du spectre de bruit, tel qu'un codeur delta-sigma, dont la fréquence de travail est supérieure à celle du signal numérique issu de filtre numérique unique; il est alors prévu avantageusement un filtre interpolateur disposé entre la sortie du filtre numérique unique et l'entrée du convertisseur numérique analogique.

Lorsque les signaux à traiter sont susceptibles de répondre aux normes CCITT G722 ou CCITT G711, il s'est avéré avantageux d'utiliser un filtre récursif série du type pôle-zéro dont l'ordre est au moins égal à 8, et de préférence égal à 8.

Par ailleurs, afin de minimiser la consommation en énergie, le dispositif comporte avantageusement des moyens capables d'adapter la fréquence de travail du filtre numérique compte tenu de la fréquence d'échantillonnage du signal d'entrée du filtre et de son débit.

D'autres avantages et caractéristiques de l'invention apparaîtront à l'examen de la description détaillée d'un mode de réalisation de l'invention nullement limitatif et illustré sur les dessins annexés sur lesquels :

- la figure 1 est un synoptique schématique d'un mode de réalisation d'un dispositif selon l'invention,
- les figures 2a et 2b illustrent des gabarits fréquentiels d'affaiblissement élémentaires en émission et en réception -spécifiés par la norme CCITT G711,
- les figures 3a et 3b illustrent de tels gabarits élémentaires pour la norme CCITT G722,
- la figure 4 illustre un gabarit fréquentiel d'affaiblissement pour un filtre numérique unique utilisable dans l'invention, et
- la figure 5 représente schématiquement un mode de réalisation d'un filtre numérique répondant au gabarit fréquentiel de la figure 4.

Bien que l'invention n'y soit nullement limitée, comme évoqué plus haut, on va maintenant décrire un mode de réalisation de l'invention permettant d'effectuer une conversion analogique/ numérique et numérique/analogique de signaux audiofréquences reçus et délivrés par exemple dans un téléphone du type mains libres.

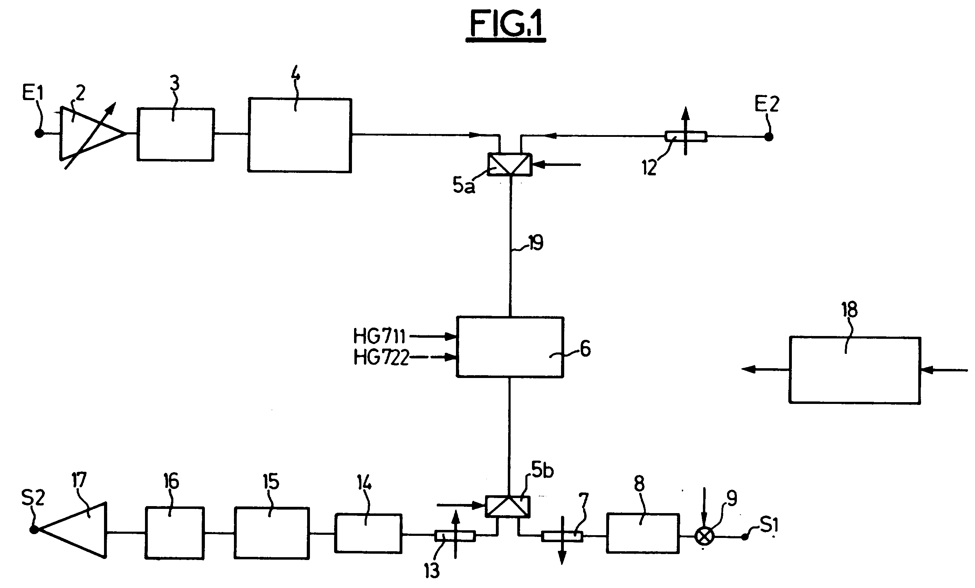

Tel qu'illustré sur la figure 1, le dispositif 1 comporte une première entrée E1 reliée par l'intermédiaire d'un canal de transmission analogique au microphone du téléphone. Cette entrée E1 est reliée à l'entrée d'un amplificateur à gain variable 2 suivi d'un codeur analogique/numérique 3 à mise en forme du spectre de bruit, par exemple un codeur delta-sigma d'ordre 3. Les codeurs delta-sigma sont des types particuliers de codeurs à mise en forme du spectre de bruit dont le but est de repousser une partie de la puissance du bruit à l'extérieur de la bande passante du signal d'entrée, c'est-à-dire de procéder à une mise en forme de ce spectre de bruit. La structure générale de tels codeurs a fait l'objet de nombreuses publications, en particulier le brevet français n° 82 15 857 dont le contenu est à toutes fins utiles incoporé à la présente description. L'homme du métier pourra s'y référer éventuellement pour plus de détails.

Le codeur 3 est suivi d'un filtre numérique 4 constitué ici d'un bloqueur d'ordre 4 dont la fonction de transfert est modifiable sur commande selon la nature du signal et donnée par la formule

$$(I) \qquad ((1 - z^{-32}) / (1 - z^{-1}))^4$$

ou par la formule

$$(II) \qquad ((1 - z^{-64}) / (1 - z^{-1}))^4$$

Le but de ce filtre est d'effectuer un préfiltrage du signal numérique pour éliminer la majeure partie du bruit et de réduire la fréquence d'échantillonnage du signal numérique. En effet, alors que la fréquence d'échantillonnage du signal en sortie du codeur 3 est ici de l'ordre de 2 MHz, la fréquence d'échantillonnage du signal issu du filtre 4 est de 64 kHz (formule (I)) ou de 32 kHz (formule (II)).

Le bus de sortie du filtre numérique 4 est un bus série alors que le bus d'entrée est un bus parallèle. Aussi, est-il prévu de disposer en sortie du filtre 4 un registre parallèle/série, ou mieux, de réaliser un filtre numérique 4 fonctionnant en partie en parallèle et en partie en série.

La sortie du filtre numérique 4 est reliée par l'intermédiaire d'un multiplexeur Sa et d'un bus numérique série 19 à l'entrée d'un filtre numérique série 6, du type récursif en échelle à réponse impulsionnelle infinie. La structure d'un tel filtre sera explicitée plus en détail ci-après.

La sortie de ce filtre 6 est reliée par une autre partie du bus série 19 et par l'intermédiaire d'un démultiplexeur 5b à des moyens de sous-échantillonnage 7 du signal numérique issu du filtre 6. La sortie des moyens d'échantillonnage 7 est reliée à un filtre numérique passe-haut 8, dont le but est d'éliminer la composante continue du signal. La sortie de ce filtre passe-haut 8 est reliée à un multiplieur dont la sortie est reliée à une première sortie S1 du dispositif. Selon la nature du signal de sortie du filtre passe-haut, celui-ci est multiplié par un coefficient multiplicateur différent afin de réaliser un ajustement de niveau du signal de sortie.

Alors que la première entrée E1 et la première sortie S1 délimitent une première voie de transmission, ici la voie d'émission, le dispositif 1 comporte une deuxième entrée E2 et une deuxième sortie S2 délimitant une deuxième voie de transmission, ici la voie de réception. A la deuxième entrée E2 est relié un moyen de suréchantillonnage 12 du signal numérique reçu à cette entrée. La sortie du moyen 12 est reliée à l'autre entrée du multiplexeur 5a. La deuxième voie de transmission se poursuit par le bus 19 et le filtre numérique 6, en commun avec la première voie de transmission. La deuxième sortie du démultiplexeur 5b est suivie d'un autre moyen de suréchantillonnage 13 dont la sortie est reliée à un codeur numérique/ analogique 15, (également à mise en forme de bruit, en l'espèce un codeur delta-sigma d'ordre 2), par l'intermédiaire d'un filtre numérique/ interpolateur 14 par exemple en sinc$^2$ (sinus cardinal au carré). En effet, la fréquence d'échantillonnage du codeur numérique/analogique 15 est supérieure à la fréquence de suréchantillonnage du signal issu du moyen 13. Le filtre interpolateur 14 permet cette augmentation de fréquence d'échantillonnage tout en préservant la qualité du signal numérique.

La sortie du codeur 15 est suivie d'un filtre analogique 16 et d'un amplificateur 17 dont la sortie est reliée à la deuxième sortie analogique S2 reliée au haut-parleur du téléphone.

Il est également prévu des moyens 18 de commande et de contrôle du dispositif pour modifier la fonction de transfert du filtre d'entrée 4 et pour délivrer les signaux de commande des différents multiplexeurs, moyens de suréchantillonnage ou de sous-échantillonnage, et comportant également une boucle à verrouillage de phase ainsi qu'un séquenceur pour délivrer des signaux d'horloge de fréquences différentes pour le cadencement des différents éléments du dispositif.

Le dispositif selon l'invention est capable de traiter des signaux analogiques et numériques répondant aux normes de transmission CCITT G722 ou CCITT G711. Ainsi, la norme de transmission G711 spécifie le codage d'un signal audiofréquence avec une largeur de bande de 4 kHz en vue de sa transmission sur un bus numérique à un débit inférieur ou égal à 32 kbit/s, typiquement avec une fréquence d'échantillonnage de l'ordre de 8 kHz, tandis que la norme CCITT G722 spécifie le codage d'un signal audiofréquence d'une largeur de bande de 7 kHz en vue de sa transmission sur un bus numérique avec un débit inférieur ou égal à 64 kbit/s, et une fréquence d'échantillonnage typiquement de l'ordre 16 kHz.

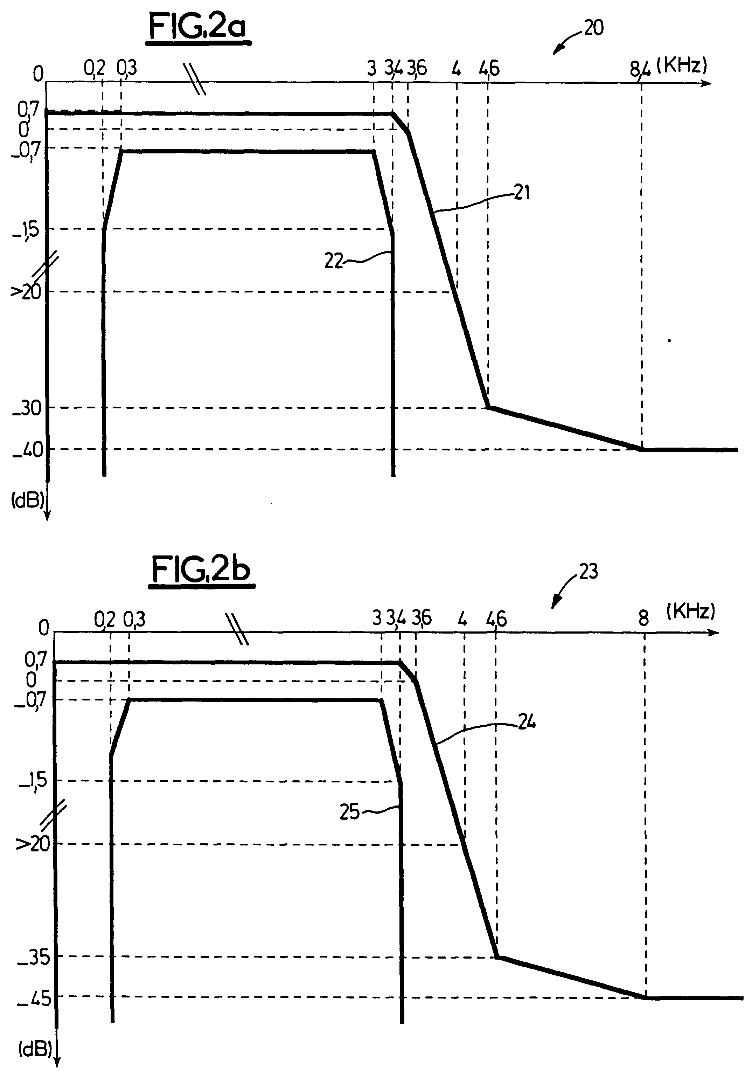

La norme CCITT G711 spécifie également que le dispositif de codage doit posséder un filtre ayant, en émission, un gabarit fréquentiel d'affaiblissement tel que celui illustré sur la figure 2a et, en réception un gabarit fréquentiel tel que celui illustré sur la figure 2b.

Ainsi, le gabarit 20 du filtre d'émission de la norme G711 montre que ce filtre passe-bas possède une fréquence de coupure de 3,4 kHz. Ce gabarit 20 est délimité par une enveloppe supérieure 21 et une enveloppe inférieure 22. Le filtre de réception possède également une fréquence de coupure de 3,4 kHz et est défini par un gabarit 23 délimité par une enveloppe supérieure 24 et une enveloppe inférieure 25. Il convient de remarquer ici que le gabarit 23 du filtre de réception est plus sévère que le gabarit 21 du filtre d'émission puisque l'enveloppe 24 se situe en partie en-deçà de l'enveloppe homologue 21 tandis que l'enveloppe 25 se situe en partie au-dessus de l'enveloppe 22.

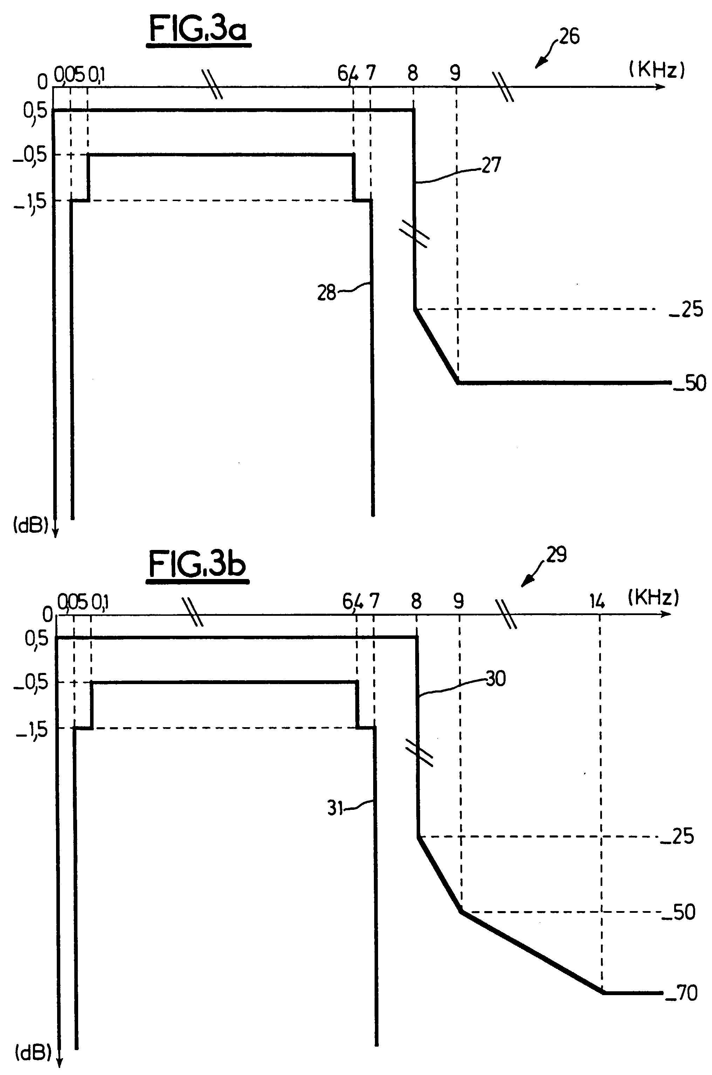

Les filtres d'émission et de réception spécifiés par la norme CCITT G722 sont des filtres passe-bas ayant une fréquence de coupure d'environ 7 kHz. Leurs gabarits respectifs 26 et 29 illustrés sur les figures 3a et 3b sont délimités par des enveloppes supérieures 27 et 30 et inférieures 28 et 31. Là encore le filtre de réception possède un gabarit fréquentiel plus sévère que celui du filtre d'émission puisque l'enveloppe supérieure 30 est située en partie en-deçà de l'enveloppe supérieure 27 du filtre d'émission tandis que l'enveloppe inférieure 31 du filtre de réception est sensiblement identique à celle 28 du filtre d'émission.

L'homme du métier pourra se référer pour plus de renseignements concernant les normes CCITT G711 et CCITT G722, aux recommandations correspondantes disponibles auprès de l'Union Internationale des Télécommunications, Place des Nations, Genève, Suisse.

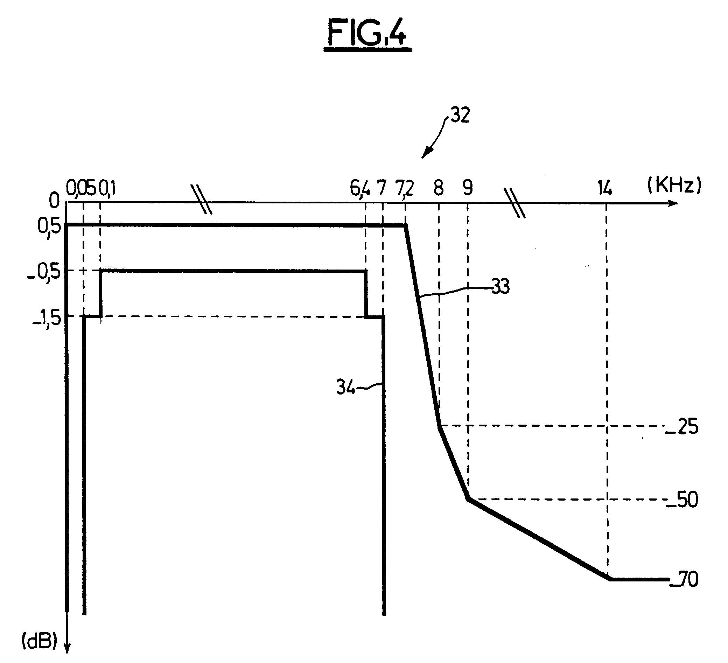

L'homme du métier remarquera que les gabarits des filtres spécifiés par les normes G711 et G722 sont sensiblement homothétiques dans un rapport d'environ 2, leurs fréquences de coupure respectives étant dans un rapport de 2 environ ce qui correspond au rapport des fréquences d'échantillonnage des signaux numériques. Une caractéristique essentielle de l'invention consiste à prévoir un filtre numérique unique, en l'espèce passe-bas, ayant une fréquence de coupure Fc fonction de la fréquence d'échantillonnage Fe du signal numérique présent à son entrée, sous la forme d'un rapport r (Fc = Fe/r), et possédant un unique gabarit fréquentiel compatible avec tous les gabarits fréquentiels élémentaires de tous les types de signaux susceptibles d'être traités. Concrètement, dans le cas présent, on choisit, pour une norme de transmission donnée, le filtre d'émission ou de réception le plus sévère, en l'espèce ici le filtre de réception. Puis, à partir des gabarits des deux filtres de réception, on détermine le gabarit fréquentiel unique du filtre résultant, de façon qu'il soit compatible avec les deux gabarits fréquentiels élémentaires les plus sévères. Dans l'exemple particulier des normes G711 et G722, on obtient, pour une fréquence d'échantillonnage donnée, un gabarit fréquentiel unique 32 illustré sur la figure 4 et possédant pour cette fréquence d'échantillonnage une fréquence de coupure de l'ordre 7 kHz avec une enveloppe supérieure 33 et une enveloppe inférieure 34. Un tel gabarit est directement compatible avec la norme de transmission G722, c'est-à-dire que l'enveloppe supérieure 33 ne sera jamais au-dessus de l'enveloppe supérieure 30 du gabarit du filtre de réception, et que l'enveloppe inférieure 34 ne sera jamais en dessous de l'enveloppe inférieure 31 de ce même gabarit. Par ailleurs, puisque la fréquence de coupure d'un tel filtre est proportionnelle à la fréquence d'échantillonnage du signal présent à son entrée, il suffira, pour obtenir un gabarit compatible avec des normes de transmission G711, de diviser par deux la fréquence d'échantillonnage du signal numérique présent à l'entrée du filtre pour obtenir une fréquence de coupure de l'ordre 3,4 kHz et un gabarit compatible avec celui des filtres d'émission et de réception de la norme G711.

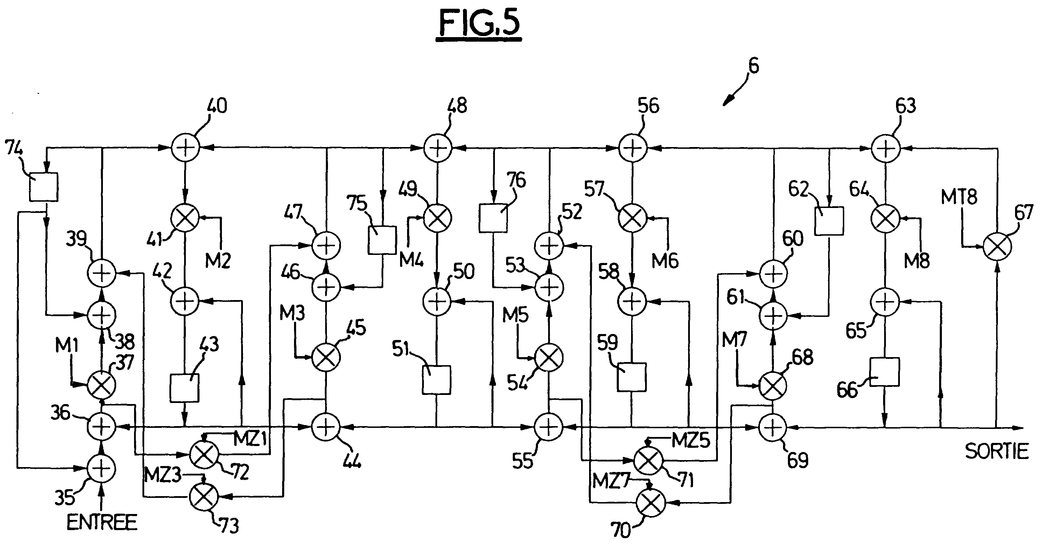

La figure 5 illustre un mode de réalisation d'un filtre récursif en échelle d'ordre 8 utilisé dans la présente application.

Ce filtre comporte essentiellement des additionneurs, des multiplieurs et des retards de fonction de transfert $Z^{-1}$. L'entrée du filtre 6 est reliée à la première entrée d'un additionneur 35 suivi, dans l'ordre et en série, d'un additionneur 36, d'un multiplieur 37 et de deux additionneurs 38 et 39. La sortie de l'additionneur 39 est rebouclée sur la deuxième entrée de l'additionneur 36 par une chaîne composée, dans l'ordre et en série, d'un additionneur 40, d'un multiplieur 41, d'un addditionneur 42 et d'un retard 43. La sortie de l'additionneur 39 est également rebouclée, par l'intermédiaire d'un retard 74, d'une part sur la deuxième entrée de l'additionneur 38 et d'autre part sur la deuxième entrée de l'additionneur 35.

La sortie du retard 43 est rebouclée sur la deuxième entrée de l'additionneur 40 par l'intermédiaire d'une chaîne composée, dans l'ordre et en série, d'un additionneur 44, d'un multiplieur 45, d'un additionneur 46 et d'un additionneur 47. La sortie du retard 43, est également rebouclée sur la deuxième entrée de l'additionneur 42 qui le précède. Par ailleurs, la sortie de l'additionneur 36 est reliée à la deuxième entrée de l'additionneur 47 par l'intermédiaire d'un multiplieur 72, tandis que la sortie de l'additionneur 44 est reliée à la deuxième entrée de l'additionneur 39 par l'intermédiaire d'un multiplieur 73.

La sortie de l'additionneur 47 est rebouclée d'une part sur la deuxième entrée de l'additionneur 46 par l'intermédiaire d'un retard 75 et, d'autre part sur la deuxième entrée de l'additionneur 44 par l'intermédiaire d'une chaîne composée, dans l'ordre et en série, d'un additionneur 48, d'un multiplieur 49, d'un additionneur 50 et d'un retard 51.

La sortie du retard 51 est également rebouclée d'une part sur la deuxième entrée de l'additionneur 50, et, d'autre part, sur la deuxième entrée de l'additionneur 48 par l'intermédiaire d'une chaîne composée, dans l'ordre et en série, d'un additionneur 55, d'un multiplieur 54, d'un additionneur 53 et d'un autre additionneur 52. La sortie de l'additionneur 52 est également rebouclée sur la deuxième entrée de l'additionneur 53 qui le précède par l'intermédiaire d'un retard 76.

La sortie de l'additionneur 52 est encore rebouclée sur l'entrée de l'additionneur 55 par l'intermédiaire d'une autre chaîne constituée dans l'ordre et en série d'un additionneur 56, d'un multiplieur 57, d'un additionneur 58 et d'un retard 59. La sortie du retard 59 est rebouclée d'une part sur la deuxième entrée de l'additionneur 58, et d'autre part sur la deuxième entrée de l'additionneur 56 par une chaîne constituée, dans l'ordre et en série, d'un additionneur 69, d'un multiplieur 68, d'un additionneur 61 et d'un autre additionneur 60.

Par ailleurs, la sortie de l'additionneur 55 est reliée à la deuxième entrée de l'additionneur 60 par l'intermédiaire d'un multiplieur 71 tandis que la sortie de l'additionneur 69 est reliée à la deuxième entrée de l'additionneur 52 par l'intermédiaire d'un multiplieur 70.

En outre, la sortie de l'additionneur 60 est reliée d'une part à la deuxième entrée de l'additionneur 61 qui le précède par l'intermédiaire d'un retard 62 et, d'autre part à la deuxième entrée de l'additionneur 69 par une chaîne constituée, dans l'ordre et en série, d'un additionneur 63, d'un multiplieur 64, d'un additionneur 65 et d'un retard 66.

La dernière boucle de ce filtre est formée d'un multiplieur 67 qui relie la sortie du retard 66 à la deuxième entrée de l'additionneur 63, la sortie du retard 66 étant par ailleurs également reliée directement à la deuxième entrée de l'additionneur 65 qui le précède. La sortie du filtre est formée par la sortie du retard 66.

La fonction de transfert de ce filtre d'ordre 8 comporte des pôles et des zéros. Les coefficients du filtre M1 à M8 et MT8, MZ1, MZ3, MZ5 et MZ7, sont respectivement appliqués aux multiplieurs 37, 41, 45, 49, 54, 57, 68, 64, 67, 72, 73, 71 et 70.

Les coefficients de ce filtre, dont les valeurs sont données en annexe, ont été calculés pour une fréquence d'échantillonnage du signal numérique présent à l'entrée du filtre de 64 kHz et pour le gabarit fréquentiel illustré sur la figure 4 avec une fréquence de coupure de l'ordre 7 kHz correspondant au mode de transmission G722. Ces coefficients intègrent également une correction d'un bloqueur d'ordre 4 en $sinc^4$ pour tenir compte de la perturbation apportée par le filtre d'entrée 4.

Un tel filtre numérique, a une fréquence de coupure inversement proportionnelle à la fréquence d'échantillonnage du signal numérique présent à l'entrée. Aussi, pour obtenir le gabarit fréquentiel utilisable en mode G711, il suffira de présenter à l'entrée du filtre 6 un signal numérique à une fréquence d'échantillonnage moitié de celle pour laquelle il a été spécifié, c'est-à-dire une fréquence d'échantillonnage de 32 kHz dans le cas présent.

Le signal numérique issu de l'entrée E2, a été en fait suréchantillonné avant filtrage afin d'éviter les problèmes de repliement de fréquences bien connus de l'homme du métier. Par ailleurs, le signal issu du filtre numérique et destiné à la sortie analogique S2 est suréchantillonné dans le suréchantillonneur 13, au moins en ce qui concerne la norme de transmission G711 de façon à obtenir une fréquence d'échantillonnage de 64 kHz en entrée de l'interpolateur 14, la fréquence de sortie étant de l'ordre de 256 kHz.

Par ailleurs, le signal numérique issu du filtre 6 mais destiné à la sortie numérique S1 est sous-échantillonné dans le sous-échantillonneur 7 de façon à obtenir au niveau du filtre passe-haut 8 une fréquence d'échantillonnage de 16 kHz.

Compte tenu du multiplexage des échantillons numériques issus respectivement de la sortie du filtre 4 (dont la fonction de transfert a été adaptée en fonction de la norme utilisée (formule I: G722; formule II: G711)) et de l'entrée E2, on obtient sur le bus série 19 commun une alternance d'échantillons d'émission et de réception, qui bien entendu impose une vitesse de fonctionnement rapide du filtre 6, ce qui est compatible avec les bandes de fréquence utilisées dans la présente application. Concrètement, en mode de transmission G722, le débit d'information sur le bus 19 sera de l'ordre de 4 Mbits/seconde tandis qu'il sera de l'ordre de 2 Mbits/ seconde dans le mode de transmission G711 en raison de la division par 2 de la fréquence d'échantillonnage du signal numérique. La fréquence de travail du filtre numérique doit bien entendu être adaptée à ces débits. Elle pourrait en fait être unique quel que soit le mode de transmission pour autant qu'elle soit adaptée au débit le plus important. Néanmoins, pour des raisons de consommation il est préférable d'ajuster au mieux la fréquence de travail du filtre. Concrètement, dans le cas d'une norme de transmission G722, le circuit 18 délivre un signal d'horloge HG722 correspondant à une fréquence du travail de 4 MHz tandis que la fréquence de travail sera commutée à 2 MHz (signal d'horloge HG711) dans le cas d'une norme de transmission G711.

Il a été jugé préférable, dans l'application décrite, d'utiliser un filtre d'ordre huit pour obtenir plus de précision et une ondulation plus faible dans la bande de travail. Par ailleurs, l'utilisation d'un filtre de type "pôle-zéro" permet d'obtenir une bande de transition plus rapide par rapport à un filtre "tout pôle".

La combinaison d'un filtre numérique unique et d'un traitement en série des échantillons permet un gain de place important pour un tel circuit implanté de façon intégrée sur une pastille de silicium.

Dans le mode de réalisation décrit, l'adaptation de la norme G711 à la norme G722 ou inversement s'effectue, outre par la modification de la fréquence de travail du filtre unique 6, par l'emploi de moyens de suréchantillonnage ou de sous-échantillonnage variables et commandables, et par la modification de la fonction de transfert du filtre d'entrée 4.

Il serait également possible, en variante, de prévoir des moyens de suréchantillonnage 12 et de sous-échantillonnage 7 identiques quelle que soit la norme utilisée, de supprimer le moyen de suréchantillonnage 13, de prévoir un filtre d'entrée 4 ayant une fonction de transfert unique selon la formule (I), et de simplement diviser par deux les fréquences de travail de tous les éléments du dispositif lors d'un passage de la norme G722 à G711 sous l'action des moyens de commande 18. Concrètement, dans le cas présent, les fréquences de travail, adoptées par la norme G722, pour les éléments 2 à 4 seraient de 2 MHz et de 4 MHz pour les éléments 6, 15, 16, le coefficient de suréchantillonnage ou de sous-échantillonnage étant alors choisi égal à 4. Les fréquences de travail ci-dessus mentionnées seraient divisées par deux dans le cas de la norme G711.

## ANNEXE

| | |
|---|---|
| M1 | = -0.302886 |
| M2 | = 0.755606 |
| M3 | = -0.230629 |
| M4 | = 0.525378 |
| M5 | = -0.229252 |
| M6 | = 0.855246 |
| M7 | = -0.241719 |
| M8 | = 0.756512 |
| MT8 | = -0.483880 |
| MZ1 | = 0.0436355 |
| MZ3 | = 0.0436355 |
| MZ5 | = 0.0532919 |
| MZ7 | = 0.0532919 |

## Revendications

1. Dispositif de traitement de signaux, caractérisé par le fait qu'il comporte un filtre numérique unique (6) dont la fréquence de coupure dépend de la fréquence d'échantillonnage du signal présent à son entrée et possédant un unique gabarit fréquentiel d'affaiblissement prédéterminé (32) compatible avec une pluralité de gabarits fréquentiels d'affaiblissement élémentaires prédéterminés sensiblement homothétiques (20; 23; 26; 29) et associés à différents types de signaux susceptibles d'être traités.

2. Dispositif selon la revendication 1, caractérisé par le fait qu'il comprend une première entrée (E1) et une première sortie (S1) susceptibles respectivement de recevoir et délivrer une pluralité de signaux analogiques et de signaux numériques correspondants ayant des types de spécificités de transmission prédéterminés différents (G711, G722) et associés à des gabarits fréquentiels d'affaiblissement élémentaires prédéterminés sensiblement homothétiques (23, 29), une deuxième entrée (2) et une deuxième sortie (S2) susceptibles respectivement de recevoir et délivrer une pluralité de signaux numériques et de signaux analogiques correspondants ayant des types de spécificités de transmission prédéterminés différents (G711, G722) associés à des gabarits fréquentiels d'affaiblissement élémentaires prédéterminés différents sensiblement homothétiques (20, 26), ainsi que des premier et deuxième moyens de conversion de signal respectivement disposés entre les premières entrée et sortie et entre les deuxièmes entrée et sortie, et comportant en commun, ledit filtre numérique unique (10).

3. Dispositif selon la revendication 2, caractérisé par le fait qu'il comprend deux voies de transmission reliant respectivement les deux entrées (E1, E2) et les deux sorties correspondantes (S1, S2), ces deux voies possédant un bus série commun (19) sur lequel est connecté ledit filtre numérique série unique (6), ainsi que des moyens de multiplexage et de démultiplexage (5a, 5b) des échantillons numériques issus des signaux reçus sur les deux entrées (E1, E2).

4. Dispositif selon la revendication 3, caractérisé par le fait que la deuxième voie reliant l'entrée de signal numérique (E2) à la sortie du signal analogique (S2) comporte des moyens de suréchantillonnage (12) du signal numérique d'entrée, précédant le filtre numérique unique (6), tandis que la première voie, reliant l'entrée de signal analogique (E1) à la sortie de signal numérique (S1) comporte des moyens de sous-échantillonnage (7) du signal numérique issu du filtre numérique (6).

5. Dispositif selon l'une des revendications 2 à 4, dans lequel, pour un couple de signaux analogique et numérique correspondants de mêmes spécificités de transmission, les gabarits fréquentiels d'affaiblissement élémentaires sont différents sur la première voie et sur la deuxième voie, caractérisé par le fait que le gabarit fréquentiel d'affaiblissement (32) du filtre numérique unique (6) est choisi à partir des gabarits fréquentiels d'affaiblissement élémentaire les plus sévères (23, 29) respectivement associés à tous les couples de signaux susceptibles d'être traités.

6. Dispositif selon l'une des revendications 2 à 5, caractérisé par le fait que la première voie comporte un codeur analogique/numérique (3) à mise en forme du spectre de bruit, tel qu'un codeur delta-sigma, suivi d'un filtre numérique (4) du type bloqueur,

par le fait que le filtre numérique unique (6) incorpore un bloqueur d'ordre choisi pour compenser l'effet du filtre numérique (4) du type bloqueur,
par le fait que la deuxième voie comporte un codeur numérique/analogique (15) à mise en forme du spectre de bruit, tel qu'un codeur delta-sigma, dont la fréquence de travail est supérieure à celle du signal numérique issu du filtre numérique unique (6)
et par le fait qu'il est prévu un filtre numérique interpolateur (14) entre la sortie du filtre numérique (6) et l'entrée du codeur numérique/analogique (15).

7. Dispositif selon l'une des revendications précédentes, caractérisé par le fait que le filtre numérique unique (6) est un filtre récursif en échelle à réponse impulsionnelle infinie.

8. Dispositif selon les revendications 2 et 7 prises en combinaison, caractérisé par le fait que les premier et deuxième moyens de conversion sont aptes à traiter des signaux ayant des spécificités de transmission définies par les normes CCITT G722 et CCITT G711, et par le fait que le filtre récursif est un filtre série du type pôle-zéro d'ordre au moins égal à huit.

9. Dispositif selon la revendication 8, caractérisé par le fait qu'il comprend en outre des moyens aptes à modifier la fréquence de travail du filtre numérique unique en fonction de la norme de transmission utilisée.

10. Dispositif selon la revendication 8 ou 9, caractérisé par le fait qu'il comprend des moyens aptes à diviser par deux la fréquence de travail de tous les éléments du dispositif.

**Patentansprüche**

1. Signalverarbeitungsanordnung, dadurch gekennzeichnet, daß sie ein Einzel-Digitalfilter (6) aufweist, dessen Grenzfrequenz von der Abtastfrequenz des an seinem Eingang anliegenden Signals abhängt, und einen vorgegebenen Eigen-Frequenzgang der Dämpfung (32) besitzt, der mit einer Mehrzahl von vorgegebenen, annähernd homothetischen, elementaren Dämpfungs-Frequenzgängen (20; 23; 26; 29) kompatibel ist, welche verschiedenen, zur Verarbeitung geeigneten, Signalgruppen zugeordnet sind.

2. Anordnung nach Anspruch 1, dadurch gekennzeichnet, daß sie einen ersten Eingang (E1) und einen ersten Ausgang (S1), welche jeweils in der Lage sind, eine Mehrzahl von Analogsignalen und von entsprechenden Digitalsignalen zu empfangen bzw. abzugeben, die verschiedene vorgegebene, mit vorgegebenen, annähernd homothetischen Dämpfungs-Frequenzgängen (23, 29) verbundene Arten von Übertragungsspezifizitäten (G711, G722) besitzen, ferner einen zweiten Eingang (E2) und einen zweiten Ausgang (S2), welche jeweils in der Lage sind, eine Mehrzahl von Digitalsignalen und entsprechenden Analogsignalen zu empfangen bzw. abzugeben, die verschiedenen vorgegebenen, mit verschiedenen vorgegebenen, annähernd homothetischen, elementaren Dämpfungs-Frequenzgängen (20, 26) verbundene Arten von Übertragungsspezifizitäten (G711, G722) besitzen, sowie erste und zweite Signal-Konversionsmittel, welche jeweils zwischen den ersten Eingang und den ersten Ausgang sowie zwischen den zweiten Eingang und den zweiten Ausgang geschaltet sind und gemeinsam das genannte Einzel-Digitalfilter (6) aufweisen, umfaßt.

3. Anordnung nach Anspruch 2, dadurch gekennzeichnet, daß sie zwei Übertragungskanäle, welche jeweils zu den zwei Eingängen (E1, E2) und den entsprechenden zwei Ausgängen (S1, S2) gehören, wobei diese beiden Kanäle einen gemeinsamen Serienbus (19) besitzen, mit welchem das genannte Serien-Einzel-Digitalfilter (6) verbunden ist, sowie Multiplex- und Demultiplexeinrichtungen (5a, 5b) für die digitalen Muster, welche von der über die beiden Eingänge (E1, E2) empfangenen Signale stammen, umfaßt.

4. Anordnung nach Anspruch 3, dadurch gekennzeichnet, daß der zweite Kanal, der den Digital-Signaleingang (E2) mit dem Analog-Signaleingang (S2) verbindet, Mittel zur Über-Abtastung (12) des digitalen Eingangssignals aufweist, welche dem Einzel-Digitalfilter (6) vorgeschaltet sind, während der erste Kanal, der den Analog-Signaleingang (E1) mit dem Digital-Signaleingang (S1) verbindet, Mittel zur Unter-Abtastung (7) des von dem Digitalfilter (6) abgegebenen Digitalsignals umfaßt.

5. Anordnung nach einem der Ansprüche 2 bis 4, bei dem für ein Paar von korrespondierenden analogen und digitalen Signalen von gleichen Übertragungsspezifizitäten die Elementar-Dämpfungs-Frequenzgänge im ersten Kanal und im zweiten Kanal verschieden sind, dadurch gekennzeichnet, daß der Dämpfungs-Frequenzgang (32) des Einzel-Digitalfilters (6) auf der Grundlage der strengsten Elementar-Dämpfungsfrequenzgänge (23, 29) gewählt ist, welche jeweils mit allen zur Verarbeitung geeigneten Signalpaaren verknüpft sind.

6. Anordnung nach einem der Ansprüche 2 bis 5, dadurch gekennzeichnet, daß der erste Kanal einen Analog/Digital-Codierer (3) zur Formatsteuerung des Geräuschspektrums, wie einen Delta-Sigma-Codierer, gefolgt von einem Digitalfilter vom Sperr-Typ, umfaßt, daß das Einzel-Digitalfilter (6) eine Sperre von einer derart gewählten Ordnung enthält, daß die Wirkung des Sperr-Digitalfilters (4) kompensiert wird, daß der zweite Kanal einen Digital/Analog-Codierer (15) zur Formatsteuerung des Geräuschspektrums, wie einen Delta-Sigma-Codierer, umfaßt, dessen Arbeitsfrequenz größer ist als diejenige des von dem Einzel-Digitalfilter (6) abgegebenen Digitalsignals, und daß ein Digital-Interpolations-Filter (1$) zwischen den Ausgang des Digitalfilters (6) und den Eingang des Digital/Analog-Codierers (15) geschaltet ist.

7. Anordnung nach einem der vorangehenden Ansprüche, dadurch gekennzeichnet, daß das Einzel-Digitalfilter (6) eine rekursive Siebkette mit unendlicher Stoßantwort ist.

8. Anordnung nach den Ansprüchen 2 und 7 in Kombination, dadurch gekennzeichnet, daß die ersten und die zweiten Konversionsmittel in der Lage sind, Signale zu verarbeiten, welche durch die Normen CCITT G722 und CCITT G711 definierte Übertragungsspezifizitäten besitzen und daß das Rekursivfilter ein Reihenfilter vom Pol-Null-Typ einer Ordnung von mindestens Acht ist.

9. Anordnung nach Anspruch 8, dadurch gekennzeichnet, daß sie zusätzlich Mittel umfaßt, die in der Lage sind, die Arbeitsfrequenz des Einzel-Digitalfilters in Abhängigkeit von der verwendeten Übertragungsnorm zu modifizieren.

10. Anordnung nach Anspruch 8 oder 9, dadurch gekennzeichnet, daß sie Mittel umfaßt, die in der Lage sind, die Arbeitsfrequenz aller Elemente der Anordnung durch zwei zu teilen.

**Claims**

1. Signal processing device, characterized in that it includes a single digital filter (6), the cutoff frequency of which depends on the frequency of sampling of the signal present at its input and possessing a single predetermined frequency attenuation template (32) compatible with a plurality of substantially homothetic predetermined elementary frequency attenuation templates (20; 23; 26; 29) and associated with different types of signals capable of being processed.

2. Device according to Claim 1, characterized in that it comprises a first input (E1) and a first output (S1) capable respectively of receiving and delivering a plurality of analog signals and corresponding digital signals having different predetermined types of transmission specifications (G711, G722) and associated with substantially homothetic predetermined elementary frequency attenuation templates (23, 29), a second input (E2) and a second output (S2) capable respectively of receiving and delivering a plurality of digital signals and corresponding analog signals having different predetermined types of transmission specifications (G711, G722) associated with different, substantially homothetic predetermined elementary frequency attenuation templates (20, 26), as well as first and second signal conversion means arranged respectively between the first input and output and between the second input and output and including the said single digital filter (10) in common.

3. Device according to Claim 2, characterized in that it comprises two transmission channels respectively linking the two inputs (E1, E2) and the two corresponding outputs (S1, S2), these two channels possessing a common serial bus (19) on which the said single serial digital filter (6) is connected, as well as means (5a, 5b) for multiplexing and demultiplexing the digital samples originating from the signals received on the two inputs (E1, E2).

4. Device according to Claim 3, characterized in that the second channel linking the digital signal input (E2) to the output of the analog signal (S2) includes means (12) for oversampling the input digital signal, preceding the single digital filter (6), while the first channel, linking the analog signal input (E1) to the digital signal output (S1) includes means (7) for subsampling the digital signal originating from the digital filter (6).

5. Device according to one of Claims 2 to 4, in which, for a pair of corresponding analog and digital signals with the same transmission specifications, the elementary frequency attenuation templates are different over the first channel and over the second channel, characterized in that the frequency attenuation template (32) of the single digital filter (6) is chosen on the basis of the most severe elementary frequency attenuation templates (23, 29) associated respectively with all the pairs of signals capable of being processed.

6. Device according to one of Claims 2 to 5, characterized in that the first channel includes an analog/digital coder (3) with shaping the noise spectrum, such as a delta-sigma coder, followed by a digital filter (4) of the blocker type,

   in that the single digital filter (6) incorporates a blocking circuit of order chosen to compensate for the effect of the digital filter (4) of the blocker type,
   in that the second channel includes a digital/analog coder (15) with shaping of the noise spectrum, such as a delta-sigma coder, the working frequency of which is higher than that of the digital signal originating from the single digital filter (6)

and in that an interpolating digital filter (14) is provided between the output of the digital filter (6) and the input of the digital/analog coder (15).

7. Device according to one of the preceding claims, characterized in that the single digital filter (6) is an infinite-impulse-response recursive ladder filter.

8. Device according to Claims 2 and 7 taken in combination, characterized in that the first and second conversion means are able to process signals having transmission specifications defined by the CCITT G722 and CCITT G711 standards, and in that the recursive filter is a serial filter of the pole-zero type of order at least equal to 8.

9. Device according to Claim 8, characterized in that it further comprises means able to modify the working frequency of the single digital filter as a function of the transmission standard used.

10. Device according to Claim 8 or 9, characterized in that it comprises means able to divide, by two, the working frequency of all the elements of the device.

# FIG.1

EP 0 620 641 B1

## FIG.2a

## FIG.2b

FIG.3a

FIG.3b

# FIG.4

# FIG.5

EP 0 620 641 B1